(19) Europäisches Patentamt
European Patent Office
Office européen des brevets

(11) **EP 2 471 882 B1**

(12) **EUROPEAN PATENT SPECIFICATION**

(45) Date of publication and mention
of the grant of the patent:
**16.11.2016 Bulletin 2016/46**

(51) Int Cl.:
***C09J 4/06*** *(2006.01)*     ***C09J 133/00*** *(2006.01)*

(21) Application number: **11010167.2**

(22) Date of filing: **23.12.2011**

(54) **RADIATION-CURABLE ADHESIVE COMPOSITION AND ADHESIVE SHEET**

STRAHLENHÄRTBARE HAFTZUSAMMENSETZUNG UND HAFTFOLIE

COMPOSITION ADHÉSIVE DURCISSABLE PAR RAYONNEMENT ET FEUILLE ADHÉSIVE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2010 JP 2010291723**

(43) Date of publication of application:
**04.07.2012 Bulletin 2012/27**

(73) Proprietor: **Nitto Denko Corporation
Ibaraki-shi,
Osaka 567-8680 (JP)**

(72) Inventor: **TAKAHASHI, Tomokazu
Ibaraki-shi
Osaka 567-8680 (JP)**

(74) Representative: **Hoefer & Partner Patentanwälte mbB
Pilgersheimer Straße 20
81543 München (DE)**

(56) References cited:
**GB-A- 2 221 470**     **JP-A- 2004 075 940**
**US-A- 5 187 007**     **US-A- 5 955 512**
**US-A1- 2006 257 651**     **US-A1- 2007 190 318**
**US-A1- 2007 264 498**     **US-A1- 2008 011 415**
**US-A1- 2008 138 618**     **US-A1- 2010 233 409**
**US-B1- 6 297 076**

**Description**

BACKGROUND OF THE INVENTION

1. Field of the Invention

The present invention relates to a radiation-curable adhesive composition and an adhesive sheet.

2. Background Information

The radiation-curable adhesive composition facilitates a peeling operation by reducing adhesive characteristics from a state of strong adhesive characteristics as a result of curing by exposure to radiation.

Thus, use is preferred in relation to applications that require the contrary characteristics of strong adhesive performance and ease of peeling.

For example, an adhesive sheet is provided with an adhesive layer formed by the above type of radiation-curable adhesive composition, and is adhered to the surface of an adherend to thereby protect and fix that surface. When no longer required, the adhesive characteristics are reduced as a result of curing the adhesive agent by irradiation with radiation of the adhesive sheet attached to the adherend to thereby facilitate peeling by a gentle peeling operation of the adhesive sheet.

In particular, during dicing, an adhesive sheet used for dicing of a semiconductor wafer or the like requires an adhesive force of a level that does not allow peeling from the semiconductor wafer. On the other hand, when executing a pick-up operation after dicing, it is necessary to facilitate peeling with an adhesive force that is sufficiently low to prevent damage to the semiconductor wafer.

As a result, various adhesive sheets have been proposed (for example, see JP2005-19607A and JP2007-220694A).

Furthermore, an adhesive sheet used for dicing requires low contamination characteristics such as avoidance of residual adhesive on the semiconductor wafer, and re-peelable sheets have been proposed in an attempt to meet both these characteristics (for example, JP2001-234136A).

Generally, an adhesive sheet using a radiation-curable adhesive composition is subjected to a desired processing and then the adhesive composition is cured by irradiation with radiation to facilitate a peeling operation. In this context, proposals to reduce the peel force by using a low irradiation amount have been made for the purpose of reducing operating costs and reducing the irradiation processing time.

However, a sufficient reduction in the peel force has not been achieved when using a low irradiation amount, and there is the problem that a peel transfer contamination amount on the adherend increases.

US 5 955 512 A discloses a pressure sensitive adhesive composition which comprises an acrylic copolymer (A), an energy beam polymerizable urethane acrylate oligomer (B) and an energy beam polymerizable compound having one acryloyl group or methacryloyl group in each molecule thereof (C). The pressure sensitive adhesive composition has satisfactory pressure sensitive adherence and initial adhesion before the irradiation with energy beam and the adhesive strength thereof is sharply reduced with maintaining the rubber elasticity after the irradiation with energy beam. Further, the pressure sensitive adhesive composition ensures excellent chip alignability in the expanding step subsequent to dicing. The pressure sensitive adhesive composition provides a pressure sensitive adhesive sheet, especially, a wafer processing pressure sensitive adhesive sheet or a surface protective pressure sensitive adhesive sheet.

US 2006/257651 A1 describes a pressure-sensitive adhesive sheet for use in dicing of a workpiece which comprises a base film and at least a pressure-sensitive adhesive layer provided on the base film, wherein the pressure-sensitive adhesive layer comprises an acrylic polymer that contains at least 5% by weight of a monomer unit having an alkoxyl group in its side chain. According to the structure, there are provided a pressure-sensitive adhesive sheet for dicing that can produce good pickup performance even after a long time and a method of picking up a product worked with the pressure-sensitive adhesive sheet.

JP 2004-075940 A describes an adhesive tape for an electronic part comprising a sheet as a support and the sheet has an adhesive layer on one side, and the composition composing the adhesive layer comprises an adhesive base polymer having a hydroxy group, a compound having a hydroxy group and an unsaturated double bond, a multifunctional urethane acrylate oligomer, an isocyanate curing agent, and a radiation polymerization initiator, and the total of the hydroxy group equivalent of the adhesive base polymer and that of the compound having a hydroxy group and an unsaturated double bond is 1.0-2.0 times the isocyanate group equivalent of the isocyanate curing agent.

US 2008/011415 A1 describes a method for working an object which includes sticking the object fixed onto a supporting plate through a double faced pressure-sensitive adhesive sheet having a heat-peelable or radial ray curable pressure-sensitive adhesive layer onto a dicing adhesive tape, heating the double faced pressure-sensitive adhesive sheet or irradiating the double faced pressure-sensitive adhesive sheet, thereby removing the double faced pressure-sensitive adhesive sheet and the supporting plate from the object, dicing the object, on which the dicing pressure-sensitive adhesive sheet is stuck, and picking up a piece of the object, wherein the dicing pressure-sensitive adhesive sheet contains a substrate film and a pressure-sensitive adhesive layer formed over the film wherein the pressure-sensitive adhesive layer contains an acrylic polymer containing 5% or more by weight of a monomer having, in its side chain, an alkoxyl group, and the thickness of the pressure-sensitive adhesive layer is 1 to 50 $\mu$m.

US 2007/264498 A1 relates to a pressure-sensitive adhesive sheet for processing a semiconductor wafer or semiconductor substrate, which includes a base material and a pressure-sensitive adhesive layer which is polymerizable and curable by an energy ray, the pressure-sensitive adhesive layer being disposed on a surface of the base material, in which the pressure-sensitive adhesive layer includes a base polymer, a multifunctional acrylate-based oligomer which has an energy-ray polymerizable carbon-carbon double bond and has a molecular weight of 1000 to 2500, and a multifunctional acrylate-based compound which has an energy-ray polymerizable carbon-carbon double bond and has a molecular weight of 200 to 700.; The pressure-sensitive adhesive sheet is excellent in follow-up properties to a minute unevenness with a depth of about 0.4 to 40 $\mu$m such as a mark printed by laser irradiation, exhibits sufficient adhesive force, and can be released without the generation of adhesive residue after the purpose of adhesion has been achieved.

US 2008/138618 A1 relates to a removable pressure-sensitive adhesive composition containing an acrylic polymer, a photopolymerization initiator and a crosslinking agent, in which the acrylic polymer and the photopolymerization initiator each are chemically bonded to the crosslinking agent. Further described is a removable pressure-sensitive adhesive composition containing an acrylic polymer and a photopolymerization initiator, the composition further containing a crosslinking agent having a reactive functional group which is capable of reacting with a reactive functional group of the acrylic polymer and a reactive functional group of the photopolymerization initiator.

US 2007/190318 A1 describes a pressure-sensitive adhesive tape or sheet for dicing which is to be applied to an active surface in the state of being not wholly covered with a native oxide film. The adhesive tape or sheet includes a substrate, and a radiation-curable pressure-sensitive adhesive layer disposed on at least one side of the substrate, in which the pressure-sensitive adhesive layer contains an acrylic polymer (A) having a weight-average molecular weight of 500,000 or higher and at least one radiation-polymerizable compound (B) selected from cyanurate compounds having one or more groups containing a carbon-carbon double bond and isocyanurate compounds having one or more groups containing a carbon-carbon double bond, and the ratio of the radiation-polymerizable compound (B) with respect to 100 parts by weight of the acrylic polymer (A) is 5 to 150 parts by weight.

GB 2 221 470 A describes a sheet comprising a substrate having coated on the surface thereof an adhesive layer which comprises an adhesive (e.g. an acrylate ester polymer) and a radiation polymerizable compound (e.g. a urethane acrylate oligomer), and is characterized in that the substrate is a synthetic resin film having carboxyl-containing monomer units, e.g. a film of ethylene-(meth) acrylic acid copolymer. The sheet is used to hold semiconductor wafers while they are diced to form chips. Before pick-up the adhesive layer is irradiated (e.g. with UV or electron beam radiation) to reduce its adhesiveness so that no adhesive remains attached to the chips after pick-up.

US 6 297 076 B1 discloses a process for preparing a semiconductor device comprising the steps of adhering a back surface of a wafer, a front surface of which has been formed a circuit, onto the radiation curable adhesive layer, dicing the wafer into chips, rinsing, drying, irradiating the adhesive layer with radiation to cure said adhesive layer, expanding the adhesive sheet if necessary to make the chips apart from each other, then picking up the chips, mounting the picked chips on a lead frame, bonding, and molding to give such a structure that the back surfaces of the chips are partially or wholly in contact with a package molding resin, wherein the radiation curable adhesive layer comprises 100 parts by weight of an acrylic adhesive composed of a copolymer of an acrylic ester and an OH group-containing polymerizable monomer and 50-200 parts by weight of a radiation polymerizable compound having two or more unsaturated bonds, and the radiation curable adhesive layer has an elastic modulus of not less than 1x109 dyn/cm$^2$ after curing by irradiation with radiation.

US 2010/233409 A1 describes a dicing die-bonding film having a pressure-sensitive adhesive layer on a base material, and a die-bonding film on the pressure-sensitive adhesive layer, which, even if the semiconductor wafer is thin, is excellent in balance between holding strength of the semiconductor wafer during dicing and peeling property of its semiconductor chip obtained by dicing upon being peeled together with the die-bonding film. A dicing die-bonding film having a dicing film having a pressure-sensitive adhesive layer on a base material, and a die-bonding film formed on the pressure-sensitive adhesive layer, wherein the pressure-sensitive adhesive layer contains a polymer comprising an acrylic acid ester as a main monomer, 10 to 30 mol % of a hydroxyl group-containing monomer based on the acrylic acid ester, and 70 to 90 mol % of an isocyanate compound having a radical reactive carbon-carbon double bond based on the hydroxyl group-containing monomer, and the die-bonding film comprises an epoxy resin.

US 5 178 007 A relates to an adhesive sheet comprising a substrate having coated on the surface thereof an adhesive layer consisting of an adhesive and a radiation polymerizable compound, which compound is a urethane acrylate oligomer having a molecular weight of 3,000-10,000, preferably 4,000-8,000. The adhesive sheet is preferably used in subjecting semiconductor wafers to dicing operation and no adhesive sticks to and remains on the back side surface of the wafer chips as picked up.

SUMMARY OF THE INVENTION

The present invention is proposed in light of the above problems and has the object of providing a radiation-curable adhesive composition, and an adhesive sheet that uses the composition, that enables simple performance of a peel operation from an adherend when using a lower irradiation amount and that minimizes the peel transfer contamination amount to the adherend.

The present invention provides the followings.

[1] A radiation-curable adhesive composition comprising a base polymer that includes structural units derived from a monomer having a methacryloyl group, the composition further comprises a group that contributes to the irradiation curing, wherein the group that contributes to the curing is included as a monomer or oligomer having the group that contributes to the irradiation curing and is methacryloyl group.

[2] The radiation-curable adhesive composition according to [1], wherein the base polymer further includes a structural unit derived from a monomer having the group that contributes to the irradiation curing in the side chain thereof.

[5] An adhesive sheet comprising an adhesive layer including the radiation-curable adhesive composition any one of [1] to [2].

According to the present invention, it is possible to provide a radiation-curable adhesive composition and an adhesive sheet that uses the composition, which enable simple performance of a peel operation from an adherend when using a lower irradiation amount and that minimizes the peel transfer contamination amount to the adherend.

DETAILED DESCRIPTION OF THE PREFERRED EMBODIMENTS

The radiation-curable adhesive composition according to the present invention mainly contains a base polymer that includes structural units derived from at least one of monomer that has one polymerizable carbon-carbon double bond group selected from the group consisting of a methacryloyl group (hereinafter may also simply be referred to as "monomer including polymerizable carbon-carbon double bond group").

The adhesive composition further includes a group that contributes to the irradiation curing, the group that contributes to the irradiation curing has the same group as one polymerizable carbon-carbon double bond group selected from the group consisting of a methacryloyl group in the base polymer (hereinafter may also simply be referred to as "group that contributes to the irradiation curing").

The group that contributes to the irradiation curing may exist as a monomer (or oligomer) that has the above polymerizable carbon-carbon double bond group. Furthermore, it may be bonded to a side chain of the base polymer, and in other words, the base polymer may further contain a structural unit derived from a monomer including the group that contributes to the irradiation curing, and the structural unit may be contained in a side chain of the base polymer. Moreover, depending on the method of polymerization of the base polymer, it may be contained in the monomer that forms a structural unit of the (co)polymer that constitutes the base polymer. Of the above configurations, the group that contributes to the irradiation curing preferably is bonded to a side chain of the base polymer.

In the following description, the type of group that is selected from an acryloyl group or a methacryloyl group may be denoted as "(meth)acryloyl group". Furthermore the term "(meth) acryl group" denotes the inclusion of both acrylic and methacrylic forms.

In the present invention, the monomer including polymerizable carbon-carbon double bond group selected from the group consisting of an acryloyl group and a methacryloyl group includes a (meth)acrylate of a saturated hydrocarbon. The saturated hydrocarbon includes, for example, a $C_1$ to $C_{30}$ hydrocarbon, preferably a $C_1$ to $C_{18}$ hydrocarbon, and more preferably a $C_4$ to $C_{18}$ hydrocarbon.

Examples of the saturated hydrocarbon includes an alkyl group, cycloalkyl group and a combination thereof, in particular, alkyl (meth)acrylate, cycloalkyl (meth)acrylate.

Examples of the alkyl group include methyl, ethyl, butyl, 2-ethylhexyl, octyl, decyl, dodecyl, tridecyl, octadecyl.

Examples of the cycloalkyl group include cyclopropul, cyclobutyl, cyclohexyl.

The base polymer in the radiation-curable adhesive composition according to the present invention may include a structural unit derived from a monomer that is capable of copolymerizing (hereinafter referred to as "copolymerizing monomer") as a structural unit derived from the monomer including polymerizable carbon-carbon double bond group selected from the group consisting of a methacryloyl group in addition to the methacrylate of a saturated hydrocarbon as described above for the purpose of modifications such as cohesive strength, heat resistance.

Examples of the copolymerizing monomer include carboxy group-containing monomers such as methacrylic acid, carboxy ethyl methacrylate, carboxy pentyl methacrylate; hydroxy group-containing monomers such as 2-hydroxyethyl methacrylate, 2-hydroxypropyl methacrylate, 4-hydroxybutyl methacrylate, 6-hydroxyhexyl methacrylate, 8-hydroxyoctyl (meth)acrylate, 10-hydroxydecyl methacrylate, 12-hydroxylauryl methacrylate, (4-hydroxymethyl cyclohexyl) methyl methacrylate; nitrogen-containing monomers in a side chain such as methacrylamide, N-hydroxymethyl amide methacrylate, aminoalkyl alkyl methacrylate, (e.g., dimethylamino ethyl methcrylate, t-butylamino ethyl methacrylate), alkoxy group-containing monomers such as methoxyethyl methacrylate, ethoxy methacrylate; sulfonic acid group-containing monomers such as 2-methacrylic amide-2-methyl propanesulfonic acid, methacryl amide propane sulfonic acid, sulfopropyl methacrylate, (meth)acryloyloxynaphthalene sulfonic acid.

These monomers may be used singly or in combinations of two or more. The acrylic monomer and methacrylic monomer are not used in combination but only methacrylic monomer is used.

Furthermore, the monomer that includes a methacryloyl polymerizable carbon-carbon double bond group that configures the base polymer may include a multifunctional monomer for the purpose of cross-linking.

Examples of the multifunctional monomer include hexanediol dimethacrylate, polyethylene glycol dimethacrylate, polypropylene glycol dimethacrylate, neopentylglycol dimethacrylate, pentaerythritol dimethacrylate, trimethylol propane trimethacrylate, pentaerythritol trimethacrylate, dipentaerythritol hexa-methacrylate, epoxy methacrylate, polyester methacrylate, urethane methacrylate.

These monomers may be used singly or in combinations of two or more. The acrylic monomer and methacrylic monomer are not used in combination but only methacrylic monomer is used.

When an acryloyl group and a methacryloyl group coexist in the radiation-curable adhesive composition of the present invention, donation and receipt of active radicals during a polymerization reaction occur from acryloyl groups to acryloyl groups, from methacryloyl groups to methacryloyl groups, from methacryloyl groups to acryloyl groups, and from acryloyl groups to methacryloyl groups. However, in particular, a polymerization reaction that is in a non-equilibrium state may occur due to the inhibition of the reaction to proceed from methacryloyl groups to acryloyl groups. Therefore, when the above monomers are used in combinations of two or more, an acrylic monomer and a methacrylic monomer are not used in combination, and only one thereof is used. Of the above configurations, uniform use of a monomer that includes a methacryloyl group is according to the invention.

In this manner, a suitable level of reactivity is obtained, and it is possible to enable both superior progression of a polymerization reaction by irradiation and prevention of unintended curing due to minute levels of ultraviolet radiation from fluorescent lighting for example. Therefore, superior peeling with a low irradiation amount can be realized together with low contamination.

In particular, the monomer that constitutes the base polymer does not include an acryloyl group but is configured by a monomer that only includes methacryloyl groups.

The base polymer is obtained by application to a polymerization reaction of a mixture of at least two substances in which the above monomers are used independently. Polymerization is performed in any configuration including solution polymerization, emulsion polymerization, bulk polymerization, suspension polymerization.

The weight average molecular weight of the base polymer is preferably at least 500,000, and more preferably at least 800,000 to 3,000,000. Since the content amount of low-molecular weight substances (that is to say, oligomers) can be reduced by adjusting the weight average molecular weight of the base polymer to this range, there are advantages in relation to prevention of contamination of an adherend, movement over time of the low-molecular weight substance within the adhesive agent is prevented, and thereby a stable radiation-curable adhesive composition can be formed. The weight average molecular weight means the polystyrene conversion value obtained from gel permeation chromatography.

The group that contributes to the irradiation curing normally derived from a monomer that includes that group. As described above, a monomer that has this type of group (hereinafter may also simply be referred to as "irradiation-curable monomer") includes at least one type of monomer that has a polymerizable carbon-carbon double bond selected from the group consisting of a methacryloyl group, or may be an oligomer of the monomer.

Examples of the irradiation-curable monomer or oligomer include trimethylol propane trimethacrylate, pentaerythritol trimethacrylate, dipentaerythritol hexa-methacrylate, tetraethylene glycol dimethacrylate, 1,6-hexanediol methacrylate, neopentylglycol dimethacrylate, ester of methacrylic acid and polyol; 2-propenyl-3-butenylcyanurate; isocyanurate, an isocyanurate compound.

These may be used singly or in combinations of two or more. The acrylic monomer and methacrylic monomer are not used in combination but only methacrylic monomer is used. Furthermore, uniform use (i.e., only methacrylic monomer) is performed with the monomer that has a polymerizable carbon-carbon double bond group that configures the base polymer as described above.

That is to say, when the polymerizable carbon-carbon double bond group of the residual monomer that occurs during production of the base polymer, and the polymerizable carbon-carbon double bond group that contributes to the irradiation curing is configured with only methacryloyl group, the polymerization reaction resulting from irradiation curing progresses without hindrance, and superior peeling and low contamination can be realized when using a low irradiation amount. Of the above configurations, uniform use of a methacryloyl group is according to the invention.

In other words, when the base polymer is configured from structural units derived from a monomer that has a methacryloyl group, the group that contributes to the irradiation curing is only a methacryloyl group. In this manner, the effect of the above description is that control characteristics in relation to the reaction are ensured to a greater degree.

Although there is no particular limitation on the composition amount when using the irradiation-curable monomer, when the reduction in the adhesive force in relation to an adherend after irradiation is considered, 1 to 100 parts by weight relative to 100 parts by weight of the base polymer in the adhesive composition is preferred, 5 to 70 parts by weight are more preferred, and 10 to 50 parts by weight still more preferred.

As described above, the irradiation-curable monomer may be bonded to a side chain of the base polymer, and may be configured as a structural unit derived from the irradiation-curable monomer. There is no particular limitation on the type of method, and any known method in this technical field may be used.

For example, there is no particular limitation on a method of introducing a polymerizable carbon-carbon double bond group into the base polymer, that is to say, in relation to the method of introducing an irradiation-curable monomer or the group that contributes to the irradiation curing into a base polymer side chain. Various methods can be used. The introduction of the irradiation-curable monomer or the group that contributes to the irradiation curing into a base polymer side chain is advantageous in light of molecular design.

These types of methods for example include a method in which a monomer that has a functional group in the base polymer is copolymerized in advance, and thereafter, a compound that has the functional group and a polymerizable carbon-carbon double bond with the functional group that results from the reaction (that is to say, the irradiation-curable monomer) is subjected to a condensation or addition reaction while maintaining the irradiation curable characteristics of the polymerizable carbon-carbon double bond.

Examples of combinations of these functional groups include a carboxy group and an epoxy group (in particular, a glycidyl group), a carboxy group and an aziridyl group, and a hydroxyl group and an isocyanate group. Of the above combinations of functional groups, a combination of a hydroxyl group and an isocyanate group is preferred in view of ease of reaction tracking. When the combination of these functional groups is a combination that produces a base polymer that has a polymerizable carbon-carbon double bond group, the functional group may be associated with either the base polymer or the compound. For example, a combination is preferred in which the base polymer has a hydroxyl group, and the compound has the isocyanate group.

A compound having the isocyanate group and the polymerizable carbon-carbon double bond group includes methacryloyl isocyanate, 2-isocyanatoethyl methacrylate.

The base polymer may be a copolymer of the above monomer that contains a hydroxy group.

The monomers having a carboxy group include methacrylic acid, carboxyethyl methacrylate, carboxypentyl methacrylate.

The monomers having a glycidyl group include glycidyl methacrylate, methylglycidyl methacrylate.

There are no particular limitation on the radiation for curing the radiation-curable adhesive composition according to the present invention. The radiation includes various types such as electric waves, electron beams, infrared radiation, visible light, ultraviolet radiation, X-rays, gamma rays

Of these types, ultraviolet radiation, electron beams, are preferred from the point of view of ease of handling, and ultraviolet radiation is still more preferred. For this purpose, a high-voltage mercury light, a low-voltage mercury light, a black light may be used. There is no particular limitation on the irradiation amount of the emitted rays for curing, and for example, it may be a level of at least 50 mJ/cm$^2$.

When the radiation-curable adhesive composition according to the present invention is cured by ultraviolet radiation a photo-polymerization initiating agent is preferably included.

Examples of the photo-polymerization initiating agent include benzoin alkyl eters such as benzoin methyl ether, benzoin ethyl ether, benzoin propyl ether, benzoin isopropyl ether, benzoin isobutyl ether; aromatic ketones such as benzoyl, benzoin, benzophenone, $\alpha$-hydroxy cyclohexyl phenyl ketones; aromatic ketals such as benzyl dimethyl ketal; thioxanthones such as polyvinyl benzophenone, chlorothioxanthone, dodecyl thioxanthone, dimethyl thioxanthone, diethyl thioxanthone.

When using the photo-polymerization initiating agent, it is preferred that 0.1 to 20 parts by weight is blended with 100 parts by weight of the base polymer constituting the adhesive, and 0.5 to 10 parts by weigh is more preferred.

The adhesive sheet according to the present invention includes the radiation-curable adhesive composition described above as an adhesive layer. Normally, the adhesive layer is formed by disposition on one base film. Furthermore, a separator may be laminated on a side of the adhesive layer opposite to the base film. However, these layers are not always configured as a single layer, but for example, there is an aspect that includes an adhesive layer on both sides of the base layer, an aspect that includes an intermediate layer, a primer layer or the like between the base layer and the adhesive layer, an aspect that includes a charge prevention layer on the back surface of the base layer, a back-surface light-peeling processed layer, a friction reduction layer, a highly-adhesive processed layer.

The adhesive sheet may be configured in a shape that is suitable for a use such in a sheet-shape, a roll-shape. For example, when used for wafer dicing, cutting and processing in advance into a predetermined shape is preferably used.

The base film is a strong mother body for the adhesive sheet. There is no particular limitation in relation to the material used in the base layer, and a film formed by a plastic material is particularly suitable.

Examples of the material of the base film includes polymers such as polyolefin (low-density polyethylene, linear polyethylene, medium density polyethylene, high-density polyethylene, super low-density polyethylene, random copolymerization polypropylene, block copolymerization polypropylene, homopolypropylene, polybutene, polymethyl pentene), ethylene-vinyl acetate copolymer, ionomer resin, ethylene-(meth)acrylate copolymer, ethylene-(meth)acrylic ester (random, alternation) copolymer, ethylene-butene copolymer, ethylene-hexene copolymer, polyurethane, polyester (polyethylene terephthalate), polyimide, polyether ketone, polystyrene, polyvinyl chloride, polyvinylidene chloride, fluoric resin, silicone resin, cellulose resin and these bridged resin.

These may be used singly or in combinations of two or more.

The constituent material may use a graft as required formed from a functional group, a functional monomer, a modified monomer.

The base film may be a single layer, or a laminated layer of two or more types.

The surface of the base layer for example may include a conductive layer formed from a metal, an alloy, an oxide compound in order to impart a charge prevention function. The conductive layer in this configuration includes for example a deposited metal and has a thickness of 3 to 50 nm.

The base layer preferably enables at least partial transmission of radiation for the purpose of irradiating the radiation-curable adhesive composition. As used herein, partial transmission means at least 50%, at least 60%, at least 70%, or at least 80%.

For the purpose of enhancing the retention properties or the sealing properties with the adjacent layer, the surface of the base layer may be subjected to typical surface processing, for example, chemical or physical processing such as mat processing, corona exposure processing, primer processing, coating processing using a primer agent, cross-linking processing, chromic acid processing, ozone exposure, flame exposure, high-voltage shock exposure, ionizing radiation processing.

There is no particular limitation on the thickness of the base layer, however it is generally 10 to 300 $\mu$m, and preferably 30 to 200 $\mu$m.

The base layer may be formed as a layer by use of a conventional and known method, and for example, includes a calendar film formation method, a casting film formation method, an inflation extrusion method, a T die extrusion method.

When forming a laminated layer, a customary film lamination method may be used such as a co-extrusion method, a dry lamination method.

The base layer may be used without stretching, or may be subjected to uniaxial or biaxial stretching as required.

The adhesive layer is formed by the radiation-curable adhesive composition described above.

The method for forming the adhesive layer may employ a conventional and known method, and for example, includes a method of direct coating of a constituent material for the adhesive layer onto the base layer surface, a method of coating and drying a constituent material for the adhesive layer onto a sheet coated with a peeling agent to thereby form the adhesive layer, and then transferring same onto the base layer.

The thickness of the adhesive layer is preferably within the range of 1 to 50 $\mu$m. The adherend that is attached to the adhesive sheet may vibrate during processing (for example, during dicing). When the amplitude is large, a notch (chipping) may be produced in the adherend (for example, a cut chip). However, when the thickness of the adhesive layer is no more than 50 $\mu$m, an excessive increase in the amplitude of the vibration produced during dicing of the adherend can be inhibited. As a result, a configuration is achieved in which production of a notch in the cut chip, that is to say, chipping can be reduced. On the other hand, when the thickness of the adhesive layer is at least 1 $\mu$m, retention of the adherend is ensured so that the adherend does not easily undergo peel during dicing.

The adhesive layer is more preferably within the range of 3 to 20 $\mu$m. In this manner, a reducion in chipping can be further enhanced, and fixing of the processed object during dicing is more accurately executed to thereby prevent production of a malfunction during dicing.

The separator includes the function of protecting the adhesive layer, label processing, and smoothing the surface adhesive layer.

The constituent material of the separator includes paper, a synthetic resin film such as polyethylene, polypropylene, or polyethylene terephthalate.

As required, a peeling process such as a silicone process, a long-chain alkyl process, a fluorine process, may be executed to increase the peeling performance of the surface of the separator from the adhesive layer. Furthermore, as required, an ultraviolet protective process may be executed to prevent a reaction on the adhesive layer as a result of ultraviolet radiation. The thickness of the separator is normally 10 to 200 $\mu$m, and preferably is 25 to 100 $\mu$m.

The adhesive sheet according to the present invention may be used for adhesion to various adherends such as a semiconductor wafer, a semiconductor package, glass, a ceramic.

Generally, after manufacture in a large diameter configuration, a semiconductor wafer composed of silicon, germanium, gallium arsenide, is subjected to rear surface grinding (back grinding) to a predetermined thickness, and, as required, is subjected to surface processing (etching, polishing). Next, a dicing adhesive sheet that is fixed to a ring-shaped tool termed a dicing frame is attached to the back surface of the semiconductor wafer, and cutting and separation into component pieces (dicing) is performed. Next, various processing steps including a washing process, expanding process, pick-up process, and mounting process are executed.

The adhesive sheet according to the present invention may be preferably used in a manufacture process for this type of semiconductor apparatus, and for example, may be used as a surface protective sheet or fixing sheet for back grinding of a semiconductor wafer, a surface protective sheet or fixing sheet for dicing of a semiconductor wafer, a protective sheet for a semiconductor circuit.

More specifically, the adhesive sheet according to the present invention is firstly aligned and attached to a semiconductor wafer such as a semiconductor component (mounting process). The mounting process is configured to stack the semiconductor wafer and the adhesive sheet so that the adhesive layer side is the adhered surface, and then press with a pressing means such as a pressing attachment roll. Furthermore, the semiconductor wafer and the adhesive sheet are stacked in a container that can be pressurized (for example, an autoclave), and thereby adhesion is enabled by pressurizing in the container. In this context, adhesion may be executed by pressing with a pressing means. Furthermore, adhesion may be executed in a vacuum chamber. Although there is no limitation in relation to an adhesion temperature during adhesion processing, a temperature for example of 20 to 80 degrees C is preferred.

Next, the semiconductor wafer is diced (dicing step). The dicing step is executed to manufacture as semiconductor chip by configuration of the semiconductor wafer into individual pieces. For example, dicing is executed by high speed rotation of a blade from the side mounting the circuit surface of the semiconductor wafer, and cutting of the semiconductor wafer into a predetermined size. Furthermore, a cutting method that is termed a full cut in which cutting is executed up to the adhesive sheet may be employed. The cutting method may employ a known method such as a method using a high rotation speed blade, or a laser in the ultraviolet, infrared, or visible spectrums, a method of forming a notch on the surface with a diamond cutter and partitioning with an external force, a method of forming a defect layer in an inner portion oriented with respect to the direction of thickness of the cut body and then partitioning with an external force. At that time, since adhesion and fixing is enabled by the adhesive sheet, chip fracture or chip fly of the semiconductor wafer can be suppressed, and damage to the semiconductor wafer can be suppressed.

Then, the semiconductor chip is picked up (pick-up process). The pick-up process is executed in order to peel the semiconductor chip that is adhered and fixed to the adhesive sheet. There is no particular limitation in relation to the pick-up method. Various conventional and known methods may be used, and for example, it includes a method in which individual semiconductor chips are raised upwardly from the adhesive sheet by a needle, and the raised semiconductor chips are picked up by a pick-up apparatus.

Before the pick-up operation, an irradiation process is applied to the adhesive layer. In this manner, the adhesive properties are reduced and the pick-up operation is facilitated. There is no particular limitation on the conditions such as the radiation intensity when executing irradiation, or the irradiation time, and such settings may be suitably determined as required.

An example of a radiation-curable adhesive composition and an adhesive sheet according to the present invention will be described in detail below.

Preparation of Base Polymer Solution

As shown in Table 1, a thermal polymerization initiating agent and a solvent were placed in the presence of a predetermined monomer (units: parts by weight).

A thermal polymerization initiating agent of 0.2 wt% of 2,2'-azobis(isobutyronitrile) (manufactured by Kishida Chemical Co., Ltd.) was used relative to the total amount of monomer. An solvent of ethyl acetate was used as 50 wt% relative to the total amount of monomer.

The mixture was introduced into a polymerization experimental apparatus including a 1 liter-separable distilling flask, a separable cover, a separating funnel, a thermometer, a nitrogen introduction pipe, a Liebig condenser, a vacuum seal, a stirring rod, and a stirring blade.

While stirring the introduced mixture, the nitrogen was replaced hourly at an ambient temperature. While stirring during inflow of nitrogen, control was executed to maintain the solution temperature in the experimental apparatus with a water bath at 60 degrees C $\pm$ 2 degrees C, and was maintained for six hours to thereby obtain a base polymer (BP). During polymerization, ethyl acetate was dripped as suitable in order to prevent a rapid increase in viscosity resulting from hydrogen bonding caused by polar groups or the like in the monomer side chains in order to control the temperature during polymerization.

Introduction of Polymerizable Carbon-Carbon Double Bond Group to Side Chain of Base Polymer

The resulting base polymer solution was cooled to room temperature, and as shown in Table 1, 2-isocyanatoethyl acrylate (Karenz AOI; manufactured by Showa Denko K.K) or 2-isocyanatoethyl methacrylate (Karenz MOI; manufactured by Showa Denko K.K) was added, dibutyltin IV dilaurate (Wako Pure Chemical Industries Limited) was added, in an atmosphere of air, stirring is executed for 24 hours at 50 degrees C, and maintained to thereby obtain a polymer solution.

Preparation of Adhesive Solution

A photopolymerization initiating agent, a polyisocyanate crosslinking agent, and ethyl acetate were mixed and uniformly stirred into the resulting base polymer solution to thereby obtain an adhesive agent solution.

The photopolymerization initiating agent was added as 3 parts by weight of 1-hydroxy-cyclohexyl-phenyl-ketone (Irgacure 184 manufactured by Chiba Specialty Chemicals Inc.) to the base polymer, and a polyisocyanate crosslinking agent (Coronet L; manufactured by NIPPON POLYURETHANE INDUSTRY Co., Ltd.) was added by three parts by weight to the base polymer.

Ethyl acetate was added so that the solid content ratio was 25 wt%.

U-4HA that contains an acryloyl group as an irradiation-curing oligomer (irradiation curing O) (manufactured by Shin-Nakamura Chemical Co., Ltd) or U-4H that contains an methacryloyl group (manufactured by Shin-Nakamura Chemical Co., Ltd) was added as an irradiation-curing oligomer (irradiation curing O) to the mixture as shown in Table 1, to thereby obtain an adhesive agent solution.

Preparation of Adhesive Sheet

The resulting polymer solution or adhesive agent solution was coated with an applicator onto a peel processed surface of a PET film that has been subjected to a silicon peel process, was dried for two hours in a drying apparatus at 80 degrees C to thereby obtain an adhesive layer having a thickness of 10 $\mu$m.

A straight-chain low-density polyethylene resin was formed as a base film by a T die extrusion method, and one surface is subjected to a corona process to thereby prepare a film having a thickness of 100 $\mu$m.

An adhesive layer was adhered with a hand roller to the surface of the base layer subjected to corona processing, and tight adhesive processing was executed for 72 hours at a temperature of 50 degrees C to thereby prepare an adhesive sheet.

Evaluation of Peel Transfer Contamination Properties

The resulting adhesive sheet was aligned and adhered to a mirror silicon wafer subjected to a mirror surface processing respectively at 23 degrees C (room temperature) (trade name: CZN < 100 > 2.5 - 3.5 (4 inch), manufactured by Shin-Etsu Semiconductor), and left for one hour.

Then, irradiation was performed from the back surface of the tape with ultraviolet rays in accordance with the two conditions below, and the surface carbon element ratio $C_1$(%) of the peeled silicon wafer surface was measured using an ESCA apparatus.

The surface carbon element ratio $C_2$(%) of the mirror silicon wafer surface was measured using an ESCA apparatus. The measurement conditions were described below.

Then, a surface organic material contamination increase amount $\Delta C$(%) was calculated using the following equation based on the respective values of $C_1$(%) and $C_2$(%).

$$\Delta C(\%) = \text{surface carbon element ratio } C_1(\%) - \text{surface carbon element ratio } C_2(\%)$$

The rate of change in the conditions was calculated using the equation, and the calculation result was deemed to be unsatisfactory when the rate of change was 10% or more.

Evaluation of Adhesive Force after Ultraviolet Irradiation

The adhesive sheet above was cut into a 25 mm width and a 150 mm length, was aligned and adhered using a 2 kg roller to a mirror silicon wafer that has been subjected to mirror surface processing respectively at 23 degrees C (room temperature) (trade name: CZN < 100 > 2.5 - 3.5 (4 inch), manufactured by Shin-Etsu Semiconductor), and left for one hour.

Then, irradiation from the back surface of the tape is performed with ultraviolet rays in accordance with the two conditions below, and peeling was executed with a peel speed of 300 mm/min and a peel angle of 90 degrees to thereby measure the adhesive force (units: N/25mm).

The rate of change under the conditions was calculated using the equation, and the calculation result was deemed to be unsatisfactory when the rate of change is 20% or more.

Conditions for Ultraviolet Irradiation

Apparatus: UM-810 Nitto Seiki Co., Ltd.
Luminance: 70 mW/cm$^2$
Irradiation Time and Luminant Energy
Condition (1): 0.5 sec, 35 mJ/cm$^2$
Condition (2): 5 sec, 350 mJ/cm$^2$

Measurement Conditions for ESCA Surface Analysis

Apparatus: Quantum 2000 manufactured by Ulvac Phi Co., Ltd.

X-ray Setting: point analysis at 200 $\mu$m$\varphi$ [30W (15 kV)]

X-ray Source: mono-chroma tor AlK$\alpha$

Photoelectron extraction angle: 45 degrees

Rate of Change under Conditions

$$\text{Rate of change under conditions} = (\text{measurement value under condition (1)} - \text{measurement value under condition (2)})/\text{measurement value under condition (1)}$$

The results are shown in Table 2 Examples 2 and 4 are according to the invention, while examples 1 and 3 not.

[Table1]

| | Containing acryloyl group | | | | | | Containing methacryloyl group | | | | | |
| | Base Polymer (BP) | | | | Irradiation Curing Group | | Base Polyme (BP) | | | | Irradiation Curing Group | |
| | | | | | Addition to side chain of BP | Irradiation Curing Oligomer | | | | | Addition to side chain of BP | Irradiation Curing Oligomer |
| | MA | 2EA | AA | 2HEA | 2IEA | U4HA | BM | LM | 2HEM | MAA | 2IEM | U4H |
| Examples | | | | | | | | | | | | |
| 1 | 70 | 20 | 10 | | | 30 | | | | | | |
| 2 | | | | | | | 95 | | | 5 | | 30 |
| 3 | | 80 | | 10 | 10 | | | | | | | |
| 4 | | | | | | | 83 | 9 | | | 8 | |
| Comparative Examples | | | | | | | | | | | | |
| 1 | 70 | 20 | 10 | | | | | | | | | 30 |
| 2 | | | | | | 30 | 95 | | | 5 | | |
| 3 | | 80 | | 10 | | | | | | | 10 | |
| 4 | | | | | 8 | | 83 | 9 | | | | |

"Irradiation CuringGroup" means the group that contributes to the irradiation curing, in shown Table 1.

MA: metylacrylate, acrylic acid methyl ester (Toagosei Co. Ltd.)
2EA: 2-ethylhexyl acrylate, acrylic acid 2-ethylhexyl ester (Toagosei Co. Ltd.)
AA: acrylate, 98% acrylic acid (Toagosei Co. Ltd.)
2HEA: 2-hydroxyethyl acrylate: Acryx HEA (Toagosei Co. Ltd.)
2IEA: 2-isocyanatoethyl acrylate, Karenz AOI (Showa Denko K.K)
BM: butylmethacrylate, Acrylester B (Mitsubishi Rayon Corporation)
LM: lauryl methacrylate, EXEPARL (Kao Corporation)
2HEM: 2-hydroxyethylmethacrylate, acrylester HO (Mitsubishi Rayon Corporation)
MAA: methacrylate (Mitsubishi Rayon Corporation)
2IEM: 2-isocyanatoethyl methacrylate, Karenz MOI (Showa Denko K.K)

[Table 2]

| | Organic Contamination Amount ΔC (%) | Adhesive Force (N/25 mm) |
| --- | --- | --- |

| | Condition (1) 35mJ/cm² | Condition (2) 350mJ/cm² | Rate of change (%) | Determination | Condition (1) 35mJ/cm² | Condition (2) 350mJ/cm² | Rate of change (%) | Determination |
|---|---|---|---|---|---|---|---|---|
| Examples | | | | | | | | |
| 1 | 7.0 | 6.8 | 2.9 | ○ | 0.25 | 0.23 | 8.7 | ○ |
| 2 | 8.5 | 8.3 | 2.4 | ○ | 0.32 | 0.30 | 6.7 | ○ |
| 3 | 4.3 | 4.1 | 4.9 | ○ | 0.12 | 0.11 | 9.1 | ○ |
| 4 | 4.2 | 4.1 | 2.4 | ○ | 0.13 | 0.11 | 18.2 | ○ |
| Comparative Examples | | | | | | | | |
| 1 | 12.5 | 7.1 | 76.1 | × | 0.51 | 0.37 | 37.8 | × |
| 2 | 14.6 | 8.9 | 64.0 | × | 0.79 | 0.56 | 41.1 | × |
| 3 | 7.4 | 4.5 | 64.4 | × | 0.32 | 0.22 | 45.5 | × |
| 4 | 9.5 | 6.5 | 46.2 | × | 0.45 | 0.31 | 45.2 | × |

Adhesive Force in Storage under Fluorescent Light

The above adhesive sheets was cut into a 25 mm width and a 150 mm length, aligned and adhered using a 2 kg roller to a mirror silicon wafer subjected to mirror surface processing respectively at 23 degrees C (room temperature) (trade name: CZN < 100 > 2.5 - 3.5 (4 inch), manufactured by Shin-Etsu Semiconductor), respectively, and left for one hour. Then, a constant adhesive force (units: N/25mm) was measured at a peel speed of 300 mm/ min and a peel angle of 90 degrees.

A test sample attaching an adhesive sheet in the same manner was left at a position 2 meters directly below fluorescent lighting (FHF32EN-S manufactured by National) for one week to illuminate the back surface of the tape, and then the adhesive force that was measured in the same manner as described above was taken as the adhesive force during storage under fluorescent light (units: N/25mm).

The rate of change under the conditions was calculated using the equation, and the calculation result was deemed to be unsatisfactory when the rate of change is 20% or more.

$$\text{Rate of change between the conditions} = (\text{constant adhesive force} - \text{adhesive force in storage under fluorescent light})/ \text{constant adhesive force}$$

The results are shown in Table 3. Examples 2 and 4 are according to the invention, while examples 1 and 3 are not.

[Table 3]

| | Adhesive force in storage under fluorescent light (N/25mm) | | |
|---|---|---|---|
| | Constant adhesive force | Adhesive force in storage under fluorescent light | Rate of Change (%) |
| Example | | | |
| 1 | 10.5 | 8.4 | 20.0 |
| 2 | 9.1 | 8.9 | 2.2 |
| 3 | 2.7 | 2.1 | 22.2 |
| 4 | 3.2 | 3.0 | 6.3 |

From Table 3, it could be confirmed that the group contributing to irradiation curing also exhibited prevention of unintended curing due to weak ultraviolet radiation from fluorescent lighting to a greater extent when the group was methacryloyl than when it was acryloyl.

The adhesive layer in the comparative examples also was confirmed to exhibit a lower tendency for unintended curing due to this type of weak ultraviolet radiation when the group contributing to irradiation curing was a methacryloyl group rather than an acryloyl group irrespective of the type of base polymer.

The radiation-curable adhesive composition and the adhesive sheet using the same according to the present invention for example can not only be used in relation to semiconductor wafers, but also can be used for attachment in relation to various adherends such as semiconductor packages, ceramics, glass, and the like, and are useful in a wide range of applications as an adhesive sheet enabling repelling for various uses such as wafer dicing, wafer protection, temporary wafer fixing for used in processing step for such adherends, and in particular for a semiconductor wafer.

## Claims

1. A radiation-curable adhesive composition comprising a base polymer that includes structural units derived from a monomer having a methacryloyl group,
   the composition further comprises a group that contributes to the irradiation curing, wherein the group that contributes to the irradiation curing is included as a monomer or oligomer having the group that contributes to the irradiation curing and is a methacryloyl group.

2. The radiation-curable adhesive composition according to claim 1, wherein the base polymer further includes a structural unit derived from a monomer having the group that contributes to the irradiation curing in the side chain thereof.

3. An adhesive sheet comprising an adhesive layer including the radiation-curable adhesive composition according to claim 1.

## Patentansprüche

1. Strahlungshärtbare Klebstoffzusammensetzung, die ein Basispolymer aufweist, das Struktueinheiten enthält, die von einem Monomer mit einer Methacryloylgruppe abgeleitet sind,
   die Zusammensetzung ferner eine Gruppe aufweist, die zum Bestrahlungshärten beiträgt und eine Methacryloylgruppe ist, wobei die Gruppe, die zum Bestrahlungshärten beiträgt, als Monomer oder Oligomer mit der Gruppe enthalten ist, die zum Bestrahlungshärten beiträgt und eine Methacryloylgruppe ist.

2. Strahlungshärtbare Klebstoffzusammensetzung nach Anspruch 1, wobei das Basispolymer ferner eine Struktureinheit umfasst, die von einem Monomer abgeleitet ist, das die Gruppe aufweist, die zum Bestrahlungshärten in deren Seitenkette beiträgt.

3. Klebefolie, die eine Klebeschicht mit der strahlungshärtbaren Klebstoffzusammensetzung nach Anspruch 1 aufweist.

## Revendications

1. Composition adhésive durcissable par rayonnement comprenant un polymère de base qui comporte des unités structurales dérivées d'un monomère ayant un groupe méthacryloyle,
   la composition comprend en outre un groupe qui contribue au durcissement par rayonnement, dans laquelle le groupe qui contribue au durcissement par rayonnement est inclus sous forme de monomère ou oligomère ayant le groupe qui contribue au durcissement par rayonnement et est un groupe méthacryloyle.

2. Composition adhésive durcissable par rayonnement selon la revendication 1, dans laquelle le polymère de base comporte en outre une unité structurale dérivée d'un monomère ayant le groupe qui contribue au durcissement par rayonnement dans sa chaîne latérale.

3. Feuille adhésive comprenant une couche adhésive comportant la composition adhésive durcissable par rayonnement selon la revendication 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005019607 A
- JP 2007220694 A
- JP 2001234136 A
- US 5955512 A
- US 2006257651 A1
- JP 2004075940 A
- US 2008011415 A1
- US 2007264498 A1
- US 2008138618 A1
- US 2007190318 A1
- GB 2221470 A
- US 6297076 B1
- US 2010233409 A1
- US 5178007 A